(19) **Europäisches Patentamt European Patent Office Office européen des brevets**

(11) **EP 4 570 878 A1**

(12) **EUROPEAN PATENT APPLICATION**

(43) Date of publication:
18.06.2025 Bulletin 2025/25

(51) International Patent Classification (IPC):
*C09K 11/02* (2006.01)          *C09K 11/70* (2006.01)
*C09K 11/75* (2006.01)          *H01L 31/0304* (2006.01)

(21) Application number: 23383278.1

(22) Date of filing: 12.12.2023

(52) Cooperative Patent Classification (CPC):
C09K 11/02; C09K 11/70; C09K 11/75;
H10F 77/124; H10F 77/1433; H10F 77/146

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
KH MA MD TN

(71) Applicants:
• **Fundació Institut de Ciències Fotòniques**
08860 Castelldefels (Barcelona) (ES)

• **Institució Catalana de Recerca i Estudis Avançats**
08010 Barcelona (ES)

(72) Inventors:
• **KONSTANTATOS, Gerasimos**
08860 CASTELLDEFELS (ES)
• **PENG, Lucheng**
08860 CASTELLDEFELS (ES)

(74) Representative: **Ponti & Partners, S.L.P**
Edifici PRISMA
Av. Diagonal núm. 611-613, Planta 2
08028 Barcelona (ES)

(54) **A QUANTUM DOT POPULATION COMPRISING INSB QUANTUM DOTS, A METHOD FOR OBTAINING THE QUANTUM DOT POPULATION AND AN OPTOELECTRONIC DEVICE COMPRISING THE QUANTUM DOT POPULATION**

(57) The present invention relates to a quantum dot population comprising InSb quantum dots, wherein the InSb quantum dots have a core-shell structure, wherein in the core-shell structure the core is made of InSb and the shell is made of InP, the InP shell being made and arranged to passivate trap states, suppress Sb oxidation, and minimize interface dangling bonds of Sb to reduce surface defects, wherein less than 10% of Sb present in each quantum dot is oxidized.

The present invention also relates to a method for obtaining the quantum dot population of the invention, and to an optoelectronic device comprising the quantum dot population.

Fig. 7

EP 4 570 878 A1

## Description

Results incorporated in this standard have received funding from the European Research Council (ERC) under the European Union's Horizon 2020 research and innovation programme (grant agreement No 101002306).

This development was partially supported by MCIN with funding from European Union NextGenerationEU(PRTR-C17.I1) and by Generalitat de Catalunya.

## FIELD OF THE INVENTION

The present invention generally relates, in a first aspect, to a quantum dot population comprising quantum dots having an InSb/InP core-shell structure.

A second aspect of the present invention relates to a method for obtaining the quantum dot population of the first aspect of the present invention.

A third aspect of the present invention relates to an optoelectronic device comprising the quantum dot population of the first aspect of the present invention.

## BACKGROUND OF THE INVENTION

Colloidal quantum dot (CQD) technology is considered the main contender towards a low-cost high performance optoelectronic technology platform for applications in the short-wave infrared (SWIR) to enable 3D imaging, LIDAR night vision, etc., in the consumer electronics and automotive markets. In order to unleash the full potential of this technology there is a need for a material that is environmentally friendly, thus RoHS compliant, possess sufficient thermal stability and adequate optoelectronic properties to deliver high performance devices. To this end, InSb CQD SWIR photodetectors hold significant application potential and commercial value due to their potential for high quantum efficiency, high speed and adequate thermal stability for CMOS integration. However, there is no report of InSb CQDs based SWIR photodetectors yet due to challenging synthesis and tremendous defects of the obtained InSb CQDs that is detrimental to the realization of optoelectronic devices. Here, the present inventors have developed a novel scalable synthesis for producing size-tunable InSb CQDs with distinct first excitonic peaks spanning a wide range from 900 nm to 1750 nm. To passivate the surface defects, enhance the photoluminescence (PL) efficiency and improve the thermal stability of InSb CQDs, the present inventors further designed a InSb/InP core-shell structure. By employing the InSb/InP core-shell CQDs in a photodiode device stack, the present inventors report the first InSb CQD SWIR photodetector that exhibits external quantum efficiency (EQE) of 25% at 1240 nm, a wide linear dynamic range exceeding 128 dB, fast photoresponse time of 70 ns, and specific detectivity of $3.6 \times 10^{12}$ Jones.

The development of short-wave infrared (SWIR, 1-2 $\mu$m) photodetectors, enables a huge number of applications, such as LIDAR and 3D imaging for mobile devices, automotive and Augmented/Virtual Reality (AR/VR), night vision for surveillance, spectroscopy for food quality inspection, and bio-imaging, etc., leading to a direct and huge impact on quality of life, health, and security, provided that such photodetectors are available at low cost and high volumes, to serve consumer electronics markets. The epitaxial technology, mainly based on indium gallium arsenide (InGaAs), has dominated the SWIR photodetector industry for decades, but only serving for niche and military markets due to the characteristics of low-scale manufacturability, high production costs, and complementary metal-oxide semiconductor (CMOS) incompatibility.

Compared to epitaxial technology, solution-processed technology based on colloidal quantum dots (CQDs) is more promising for SWIR photodetectors due to the low cost, high-volume manufacturing, and their CMOS integrability. The SWIR CQDs photodetectors developed so far rely upon the use of IV-VI semiconductors based on Pb and Hg-chalcogenides. However, Pb and Hg are elements that fall under RoHS (restriction of hazardous substances) regulations which impose severe regulatory concerns and may prevent their deployment into commercial consumer applications. Therefore, the development of SWIR photodetectors based on environmentally friendly CQDs is indispensable and highly demanded. III-V CQD photodetectors have recently been reported based on InAs, with compelling performance in the near infrared at 940 nm [1-2] whereas at longer wavelengths in the SWIR up to 1300 nm the performance plummets with maximum quantum efficiency of < 5% [3].

InSb is an environmentally friendly III-V semiconductor, free of arsenic, which possesses a narrow direct band gap (0.17 eV), the highest room temperature carrier mobility ($7.7 \times 10^4$ cm$^2$ V$^{-1}$ s$^{-1}$), and the smallest exciton binding energy (0.5 meV) of all semiconductors [4], making it an ideal alternative to Pb and Hg compounds for SWIR photodetectors. Despite the unparalleled potential of InSb semiconductor, there is no report about InSb CQDs based SWIR photodetectors to date. Although there are some recent reports on the synthesis of InSb CQDs [5-7] the realization of optoelectronic devices remains elusive likely due to the challenging synthesis and the high surface defect density of the obtained InSb CQDs.

Specifically, InSb CQDs were first synthesized by Liu et al. [5] with well-resolved excitonic transitions from 1200 nm to 1750 nm in the SWIR spectral range. Their approach consisted of the co-reduction of antimony silylamide (Sb[N(Si(Me)$_3$)$_2$]$_3$) and InCl$_3$ to Sb$^0$ and In$^0$ by lithium triethylborohydride (LiEt3BH) at room temperature, followed by heating to the growth temperature. However, antimony silylamides are not commercially available and must be directly synthesized and purified. Moreover, they are sensitive to oxygen, moisture, and light and therefore are difficult to prepare and store.

In an attempt to synthesize InSb CQDs using only commercially available compounds, Zhao et al. [6] have demonstrated a successful synthetic route to $In(As_{1-x}Sb_x)$ CQDs based on the co-reduction of commercially available In- and Pn-precursors (Pn = As, Sb). Subsequently, Busatto et al. [7] reported a "single-source" precursor method that is based on a concurrent fast co-reduction of two commercially available compounds ($Sb[NMe_2]_3$ and $InCl_3$) by injection of a solution containing stoichiometric amounts of both compounds into $LiEt_3BH$ in oleylamine at high temperature. However, in both cases, the obtained InSb CQDs suffer from poor size dispersity manifested by an absorption shoulder even after the size-selection process, instead of a distinct exciton peak. In addition, the complex size selection process will not only reduce the product yield but also adds complexity and cost in the material supply chain.

It is, therefore, necessary to provide an alternative to the state of the art by providing InSb quantum dots which do not possess the above mentioned drawbacks of those InSb quantum dots of the prior art.

SUMMARY OF THE INVENTION

To that end, the present invention relates, in a first aspect, to a quantum dot population comprising InSb quantum dots, wherein, in contrast to the prior art quantum dot populations, the InSb quantum dots have a core-shell structure, and wherein in said core-shell structure the core is made of InSb and the shell is made of InP, said InP shell being made and arranged to passivate trap states, suppress Sb oxidation, and minimize interface dangling bonds of Sb to reduce surface defects, wherein less than 10% of Sb present in each quantum dot is oxidized.

A general definition of "defect" is any localized disruption to the perfect crystalline order, which is very common in material, including point defects, dislocations, surfaces, or other categories. Quantum dots, due to their huge specific surface area, the dangling bonds caused by the vacancy of anion or cation on the surface have a huge impact on their optical and electronic properties, which are called surface defects. In InSb quantum dots, the surface indium cations could be easily passivated by halides, while the surface antimony anions are difficult to be passivated by organic molecular donors due to their lower electronegativity (2.05), compared to its III-V analogues As (2.18) and P (2.19). Once exposed to air, the dangling bonds of antimony that have not been passivated on the surface will be oxidized to form Sb oxides, hence the amount of Sb oxides is an important criterion to judge the surface defects of InSb quantum dots. To passivate the surface defects sufficiently, we decided to grow a larger bandgap material on InSb quantum dots to form a type I core-shell structure. InP is an ideal choice because it does not contain heavy-metal element and has very small lattice mismatch with InSb, which can effectively reduce crystal structure defects caused by interface stress. Moreover, compared with Sb atoms, P atoms on the surface are more easily passivated by molecular donors.

Generally, the quantum dots are colloidal quantum dots (CQDs), i.e. solution-processed semiconducting nanocrystals with diameters below 20 nm.

For an embodiment, the surface dangling bonds of the Sb of the InSb core are post-synthesis partially passivated with $InCl_3$, at least to minimize surface defects.

According to an embodiment, the InP shell partially covers the respective InSb core.

For an embodiment, the InP shell fully covers the respective InSb core with one or more layers of InP, so that less than 1% (preferably 0% or near 0%) of Sb present in each quantum dot is oxidized.

The InSb core of the core-shell structure of the quantum dot population of the first aspect of the present invention maintains the crystal structure of zinc blende, for a preferred embodiment.

According to an embodiment, the core-shell structure is tetrahedrally faceted.

For an embodiment, the InP shell is grown along the [110] zone axis of the InSb core.

The quantum dot population of the first aspect of the present invention comprises, for various embodiments, quantum dots with distinct first excitonic peaks spanning from 900 nm to 1750 nm.

For some embodiments, the quantum dot population of the first aspect of the present invention forms a structure, such as sheet, a film, or a layer, or an ink.

In a second aspect, the present invention relates to a method for obtaining the quantum dot population of the first aspect of the present invention, wherein the method comprises obtaining the core-shell structure by providing a core made of InSb and providing thereon a shell made of InP made and arranged to passivate trap states, suppress Sb oxidation, and minimize interface dangling bonds of Sb to reduce surface defects.

For an embodiment, the method of the second aspect of the present invention comprises performing the following steps:

- synthesizing InSb quantum dots via a continuous precursor injection process controlled by precisely adjusting the precursor conversion kinetics of a precursor continuously injected into a solution, for the separation of the nucleation and growth processes and avoid a secondary nucleation;
- applying a surface post-synthesis treatment of the synthesized InSb quantum dots with $InCl_3$;
- applying a purification process to the InSb quantum dots; and
- shelling the purified InSb quantum dots with the InP shell.

According to an embodiment, the above mentioned shelling step comprises growing at least part of a layer of InP using indium alkylates, such as indium oleate, and phosphine silylamide (P[N(Si(Me)3)2]3) as precursors.

For an embodiment of the method of the second aspect of the present invention, the InSb quantum dots are organic ligands capped InSb quantum dots, and the method further comprises performing a solid-state ligand-exchange on surface of the InSb quantum dots, for providing the same with ligands with a shorter chain than said organic ligands.

In a third aspect, the present invention relates to an optoelectronic device, comprising the quantum dot population of the first aspect of the present invention.

For an embodiment of the optoelectronic device of the third aspect of the present invention, the quantum dot population is provided in the form of a sheet or layer previously formed or by spin-coating or printing the above described ink onto a substrate or lower sheet or layer.

According to an embodiment, the optoelectronic device of the third aspect of the present invention implements a photodetector device, while for other embodiments the optoelectronic device implements a light emitting device or an image sensor.

For an embodiment, the optoelectronic device comprises a light absorbing structure (such as a sheet, film or layer) comprising the above described quantum dot population and made to absorb, in the visible spectrum and/or at least one of infrared light, near infrared light, and short-wavelength infrared light.

For an embodiment, the optoelectronic device constitutes a photo-detector comprising:

- a substrate;
- an electron transporting structure (generally formed by one or more layers) arranged over said substrate;
- a light-active absorbing structure arranged over the electron transporting structure and containing the quantum dot population of the first aspect of the present invention, made to absorb at least one of infrared light, near infrared light, and short-wavelength infrared light;
- an electronic blocking structure (generally formed by one or more layers) arranged over the light-active absorbing structure; and
- a top electrode arranged over the electronic blocking structure.

For various embodiments, the electron transporting structure is made of at least one of $SnO_2$, $TiO_2$, ZnO, MgZnO, aluminum doped ZnO, or combinations thereof.

For an embodiment, the optoelectronic device of the third aspect of the present invention further comprises an intermediate structure (generally formed by one or more layers) arranged between the electron transporting structure and the light-active absorbing structure, wherein the intermediate layer has a lower free carrier density than the electron transporting structure, its conduction band is lower, with respect to vacuum, than that of the electron transporting structure and larger than that of the light-active absorbing structure, and its bandgap lies in between the bandgap of the electron transporting structure and that of the light-active absorbing structure.

For various embodiments, the intermediate structure is made of at least one of: inorganic oxide and chalcogenide semiconductors, other III-V quantum dots including smaller InSb, InSb/InP core-shell quantum dots, InAs quantum dots or InP quantum dots having larger bandgap than that of the light-active absorbing structure, as well as organic semiconductors such as C60, PCBM and other non-fullerene electron acceptor materials, or a combination thereof.

BRIEF DESCRIPTION OF THE FIGURES

In the following some preferred embodiments of the invention will be described with reference to the enclosed figures. They are provided only for illustration purposes without however limiting the scope of the invention. In accordance with common practice, the components in the figures are drawn to emphasize specific features and they are not drawn to the right scale.

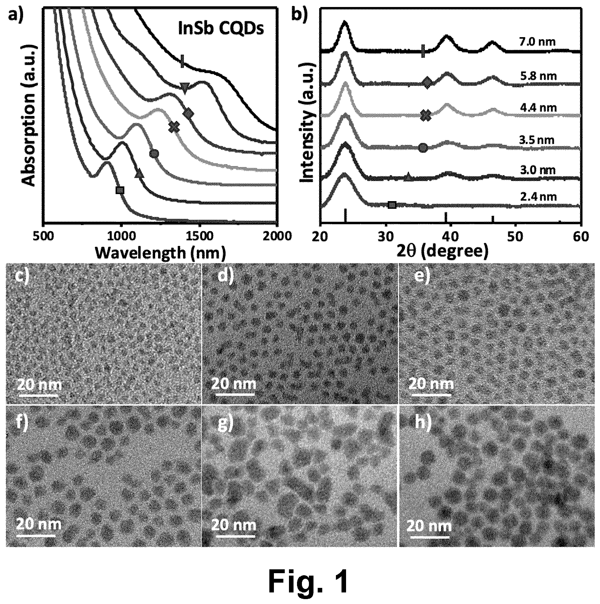

Figure 1 shows different measurements made on InSb colloidal quantum dots (QCDs): a) Absorption spectra of the InSb CQDs with different sizes, for some embodiments, wherein the first exciton peaks ranging from 900-1750 nm. b) Powder X-ray diffraction (XRD) patterns of the InSb CQDs with various sizes. c-h) Transmission electron microscope (TEM) images of 2.4 nm, 3.0 nm, 3.5 nm, 4.4 nm, 5.8 nm and 7.0 nm InSb CQDs of the first aspect of the present invention, those are corresponding to the first exciton peaks at 905 nm, 1020 nm, 1120 nm, 1260 nm, 1520 nm and 1750 nm obtained at 220 °C, 230 °C, 235 °C, 240 °C, 245 °C, 250 °C respectively.

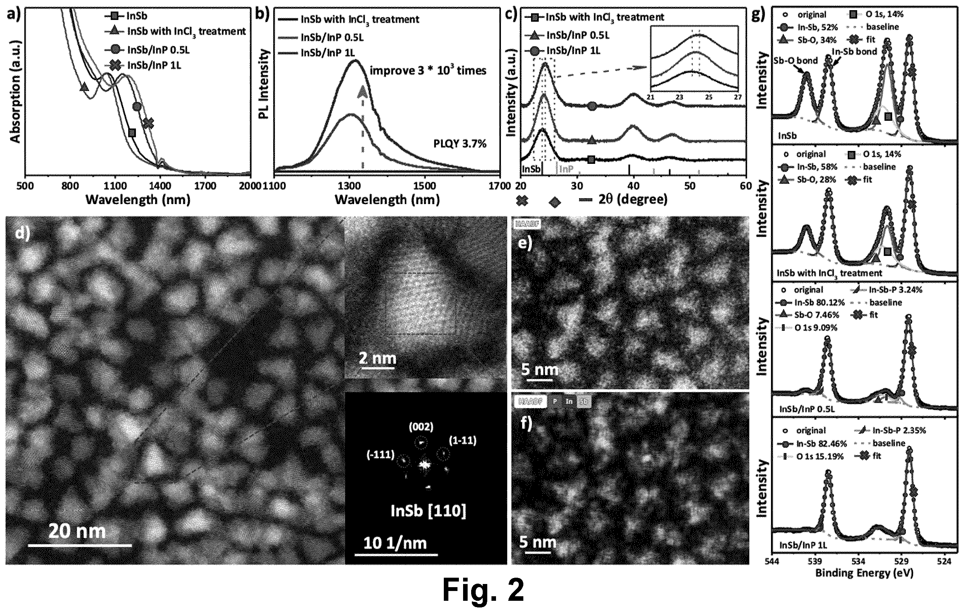

Figure 2 shows the characterizations of InSb/InP core-shell CQDs of the quantum dot population of the first aspect of the present invention, for an embodiment. a) Absorption spectra of InSb CQDs before and after an $InCl_3$ post-treatment and an InP shell growth. The first exciton absorption peak of InSb CQDs redshift from 1020 nm to 1140 nm after InP shell growth. b) Photoluminescence (PL) spectra of InSb CQDs before and after InP shell growth. The PL intensity enhanced 3*103 times after InP shell growth. c) Powder X-ray diffraction (XRD) patterns of InSb CQDs before and after InP shell growth. The diffraction peak of InSb core at 23.8° moved to high angle at 24.3° after the InP shell growth. d) High angle annular dark field scanning transmission electron microscopy (HAADF-STEM) image of InSb/InP core-shell CQDs and the corresponding fast Fourier transform (FFT) pattern. e-f) Energy-dispersive X-ray (EDX) spectroscopy mapping of InSb/InP core-

shell CQDs. g) Sb 3d X-ray photoelectron spectroscopy (XPS) analysis of InSb CQDs before and after the InCl3 post-treatment and InP shell growth. The Sb-O bond signal finally disappeared after InP shell growth.

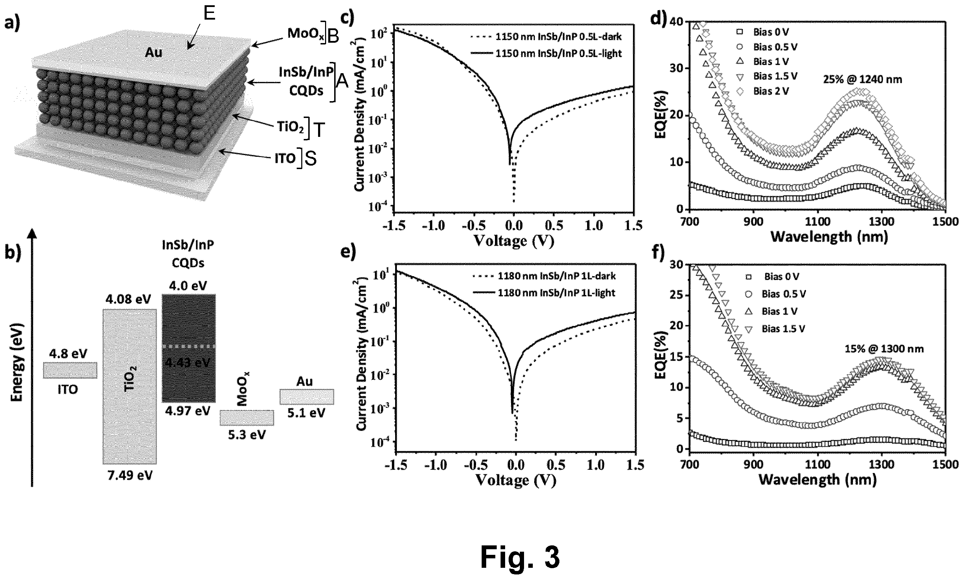

Figure 3 shows an InSb/InP CQDs short-wave infrared photodetector implementing two embodiments of the optoelectronic device of the third aspect of the present invention. a) Schematics of the InSb/InP CQDs photodetector. b) Band diagram of the InSb/InP CQDs photodetector. c) Current density-voltage (J-V) curves of an embodiment, for which the photodetector is a InSb/InP 0.5L CQDs photodetector, dark and under 1200 nm illumination with power densities of 1.5 mW cm-2. d) External quantum efficiency (EQE) spectra of the InSb/InP 0.5L CQDs photodetector biased from 0-2V. e) J-V curves of another embodiment, for which the photodetector is a InSb/InP 1L CQDs photodetector, dark and under 1200 nm illumination with power densities of 1.5 mW cm-2. f) (EQE) spectra of the InSb/InP 1L CQDs photodetector biased from 0-1.5V.

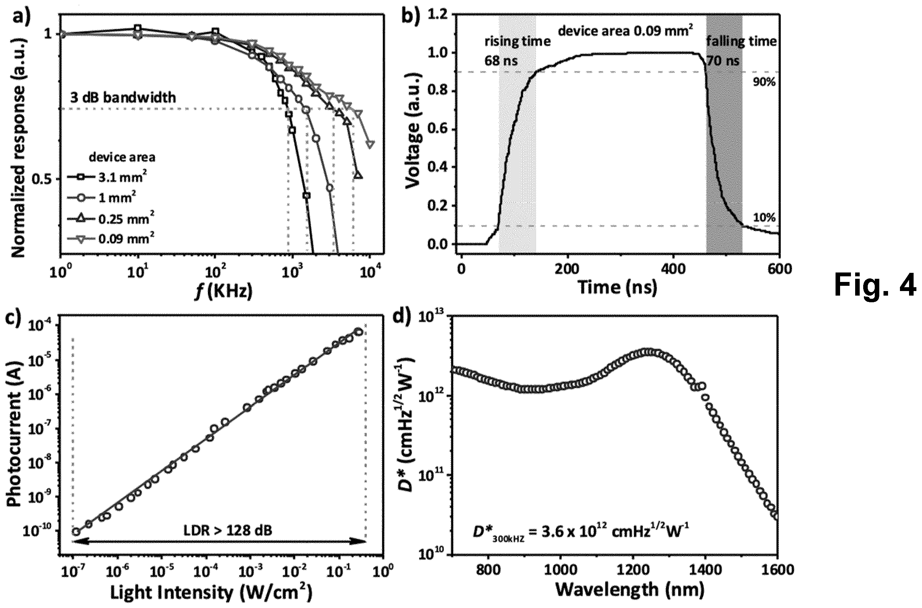

Figure 4 shows different measurements showing the performance of different InSb/InP CQDs short-wave infrared photodetectors, corresponding to different embodiments of the optoelectronic device of the third aspect of the present invention. a) Frequency response bandwidth of the InSb/InP CQDs photodetector with various device area. b) Response time of the InSb/InP CQDs photodetector with the device area of 0.09 mm2. c) Linear dynamic range (LDR) of the InSb/InP CQDs photodetector under 1310nm pulse light illumination with power densities from ~ $10^{-7}$ W cm$^{-2}$ to ~ $4 * 10^{-1}$ W cm$^{-2}$. d) Specific detectivity spectrum of the InSb/InP CQDs photodetector at 300 kHz.

Figure 5. Absorption spectra of pristine InSb and InSb/InP core-shell CQDs films as a function of annealing temperature. The absorption peak of InSb CQDs film shows some redshift with increasing temperature and almost disappeared at 200 °C (left). The absorption peak of InSb/InP core-shell CQDs film is almost constant even at temperature of 200 °C (right).

Figure 6. PLQY calculation of InSb/InP CQDs obtained in Fig 2b according to the calculation method from reference 17.

Figure 7. TEM and STEM images of InSb core and InSb/InP core-shell CQDs. The shape of CQDs evolved from near-spherical to tetrahedrally faceted after the growth of InP shell.

Figure 8. P 2p X-ray photoelectron spectroscopy (XPS) signal of InSb core and InSb/InP core-shell CQDs after solid ligand exchange with InI$_3$ as the ligand.

Figure 9. FTIR spectra of InSb CQDs films before and after InI$_3$ ligand exchange on silicon.

Figure 10. The energy level of InSb CQDs and InSb/InP core-shell CQDs films analyzed by the UPS spectra after InI$_3$ ligand exchange.

Figure 11. InSb/InP CQD photodetector characterization with the device architecture of ITO/ZnO/InSb/MoO$_x$/Au, where the ZnO layer was not annealed. Dark current density-voltage (J-V) curves of InSb/InP CQD photodetector, and the corresponding EQE spectra biased from 0 V to 1.5 V.

Figure 12. InSb/InP CQD photodetector characterization with the device architecture of ITO/ZnO/InSb/MoO$_x$/Au, where the ZnO layer was annealed at 250 °C for 30 min. Dark current density-voltage (J-V) curves of InSb/InP CQD photodetector and the corresponding EQE spectra under reverse bias from 0.2 V-1.2 V and different modulation frequency measurements.

Figure 13. The temporal photocurrent traces under pulsed illumination of InSb/InP CQDs photodetector with the device architecture of ITO/ZnO/InSb/MoO$_x$/Au, where the ZnO layer was annealed at 250 °C for 30 min.

Figure 14. Pristine InSb CQD photodetector characterization. Dark current density-voltage (J-V) curves of pristine InSb CQD photodetector, and the corresponding EQE spectrum under zero bias.

Figure 15. Larger-sized InSb/InP CQDs characterization. The absorption spectrum of 1180 nm InSb core and 1380 nm InSb/InP core-shell CQDs, and their corresponding XRD patterns.

Figure 16. Larger-sized InSb/InP CQD photodetector characterization. Dark current density-voltage (J-V) curves of InSb/InP 1L CQD photodetector, and the corresponding EQE spectra biased from 0 V to 1.5V.

Figure 17. The air stability of InSb/InP CQDs photodetector. Dark current density-voltage (J-V) curves of InSb/InP CQDs photodetector, and the corresponding EQE spectrum under zero bias.

Figure 18. The thermal stability of InSb/InP CQDs photodetector. Current density-voltage (J-V) curves of InSb/InP CQDs photodetector dark and under 1200 nm illumination with power density of 1.5 mW cm$^{-2}$ under different annealing temperatures (100 °C-10 min, 150 °C-10 min, 200 °C-10 min,) and the corresponding EQE line chart biased from 0-1.5V.

Figure 19. Frequency response bandwidth of InSb/InP CQDs photodetector under different bias.

Figure 20. The 3dB bandwidth of InSb/InP CQDs photodetector with varying device area.

Figure 21. Response time (rising time and falling time) of InSb/InP CQDs photodetector with different device areas.

Figure 22. Frequency dependent noise spectral density measurement of InSb/InP CQDs photodetector at zero bias (pixel area of 3.1 mm2). The signal has been amplified by $10^9$ V A$^{-1}$ before measurement.

Figure 23. Frequency dependent specific detectivity (D*) of InSb/InP CQDs photodetector.

DESCRIPTION OF THE PREFERRED EMBODIMENTS

In the present section, by means of several experiments detailed below, the present inventors demonstrate the feasibility and good results offered by the present invention.

Specifically, a method for the synthesis of InSb CQDs that offers wide spectral tunability, high quality of CQDs expressed in adequate size uniformity, simplicity and use of commercially available precursors and high product yield, features that are essential for use in optoelectronic device developments, is developed herein.

From the here provided results, it can be envisaged that the size and size distribution of InSb CQDs could be well-controlled by precisely adjusting the precursor conversion kinetics. This adjustment allows for the separation of the nucleation and growth processes and avoids the secondary nucleation. To do so, it was adopted the "single-source" precursor approach via a continuous precursor injection process instead of hot-injection, which allowed to obtain InSb CQDs with well-controlled size distribution and distinct excitonic peaks over a very broad range (900 nm to 1750 nm). As shown in Fig. 1a, the absorption spectra of InSb CQDs exhibit clear excitonic peaks, without any size selective precipitation, whose positions were controlled by reaction temperatures from 220 °C to 250 °C (see Experimental Methods below). The resultant spectral tuneability from near infrared to short-wave infrared, from 900 nm to 1750 nm, is the largest reported to date for InSb CQDs. The powder X-ray diffraction patterns (XRD) shown in Fig. 1b revealed a pure cubic zinc blende crystal structure of InSb CQDs, identical to that of bulk InSb. The width of diffraction peaks clearly narrows with increasing size, which is consistent with the Scherrer equation. Transmission electron microscopy (TEM) images (Fig. 1c-h) confirmed the InSb CQDs with average size of 2.4 nm, 3.0 nm, 3.5 nm, 4.4 nm, 5.8 nm and 7.0 nm that is corresponding to the first exciton peak at 905 nm, 1020 nm, 1120 nm, 1260 nm, 1520 nm and 1750 nm respectively. The present inventors also found that the relationship between size and bandgap of InSb CQDs in their case is very close to the sizing curve reported by Busatto et al. [7].

InSb/InP core-shell CQDs:

The present inventors have then further characterized the surface of the manufactured InSb CQDs, for it is known to play a key role in the optoelectronic properties of CQD materials. It has been proved the trap states of III-V CQDs originate from unpassivated dangling bonds of the surface [8]. Specifically, the dangling bonds of group V elements create much deeper trap states than group III, resulting detrimental consequences on their optoelectronic properties. X-ray photoelectron spectroscopy (XPS) analysis was performed to probe the oxidation states of Sb that corresponding to unpassivated Sb dangling bond of the surface. Fig 2g exhibits the Sb 3d XPS spectra, showing strong evidence of Sb-oxide formation (detail discussions see below). Hence, it is urgent to develop passivation strategy for the obtained InSb CQDs.

Efforts to passivate trap states in III-V CQDs, particularly InAs, have relied on the use of metal-chalcogenide shells [9-11], acid etching treatment [12] or the use of metal dopants (Zn, Cd) [13-14], that have shown promise for majority carrier devices (e.g. field effect transistors) [14] yet their potential for minority carrier based optoelectronic devices such as photodiodes or light emitters has remained elusive [11]. The acid etching treatment may introduce the blueshift of absorption, and the metal dopants do not show significant improvement compared to InP [13-14]. The zinc blende crystal structure of InSb CQDs makes them compatible with some II-VI and III-V materials. Considering the lattice mismatch, CdTe (a = 6.482 Å) is the best candidate to form a nearly strain-free interface with InSb (a = 6.479 Å). But cadmium is a heavy metal element, and on the other hand, it was noticed that InSb surface can react with Te, forming $In_2Te_3$ and Sb at elevated temperatures [15]. Moreover, it has been proved the InSb CQDs can be well-passivated by growing CdS (a = 5.832 Å) as the shell even though there is some lattice mismatch [22].

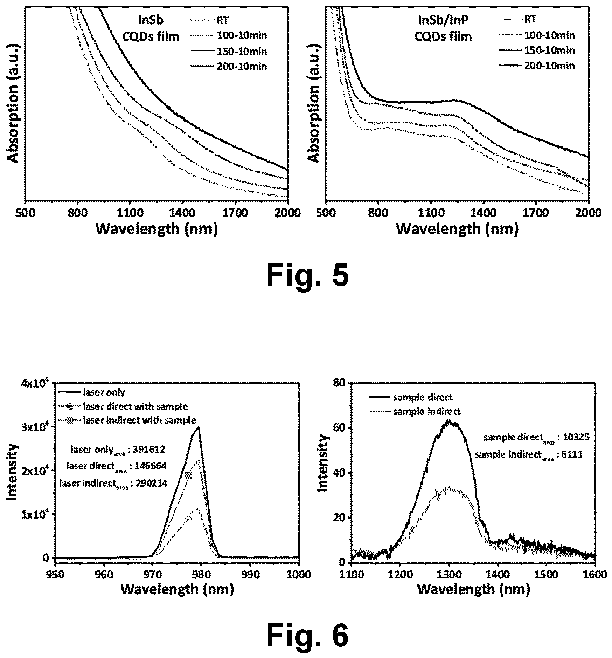

By considering the lattice mismatch and non-toxic element constraint, the present inventors therefore took the view that the use of a higher bandgap III-V semiconductor material, InP (a = 5.868 Å), would be the most appropriate choice to passivate trap states, minimize interface dangling bonds and suppress Sb oxidation. Due to the limitation of current "single-source" precursor approach, initial In/Sb ratio during the InSb CQDs preparation is 1:1, which made it difficult to produce an In-rich quantum dot surface. Therefore, the present inventors first carried out an in-situ surface post-synthesis treatment of InSb CQDs with $InCl_3$. On one hand, this treatment partially passivated the surface dangling bonds of Sb to reduce defects, and on the other hand, it improved the colloidal stability of InSb CQDs in subsequent purification processes. As shown in Fig. 2a, the InSb CQDs treated with $InCl_3$ exhibited a very clear first exciton absorption peak at 1020 nm. Then, indium oleate and phosphine silylamide $(P[N(Si(Me)_3)_2]_3)$ were used as precursors to grow 0.5 layer (i.e., to partially cover the InSb core) and 1 layer (i.e., to fully cover the InSb core) of InP shell on the purified InSb CQDs respectively. The absorption spectrum of InSb CQDs exhibit a significant red shift of approximately 120 nm to 1140 nm rather than a blue shift after the InP shell growth (Fig. 2a). This indicates a successful core-shell structure instead of alloying. Compared to ionic semiconductors, III-V covalent semiconductors are expected to show much better thermal stability that is a prerequisite for wafer level integration and overall device stability. PbS CQD films lose their quantum confinement above 150 °C [16] due to CQD fusion and necking. However, the obtained InSb CQD films show good stability at 150 °C with some redshift. Among the III-Vs InSb is the compound with lowest melting point, the present inventors posited therefore that the use of a shell made of InP (that has much higher melting point) would lend thermal stability to the final CQD. Indeed, the InSb/InP core-shell CQD films exhibit improved thermal stability preserving their quantum confinement even at 200 °C, as shown in Fig. 5. Photoluminescence (PL) spectra were first used to confirm the InSb/InP core-shell structure, as shown in Fig. 2b, the PL intensity of InSb CQDs increased by 3000 times after the InP shell growth. The present inventors then further calculated the absolute PL quantum yield (PLQY) by the integration sphere method [17], and it showed that the InSb/InP core-shell CQDs achieved a PLQY of 3.7% at 1300 nm (Fig. 6), which is the first report for InSb CQDs to date.

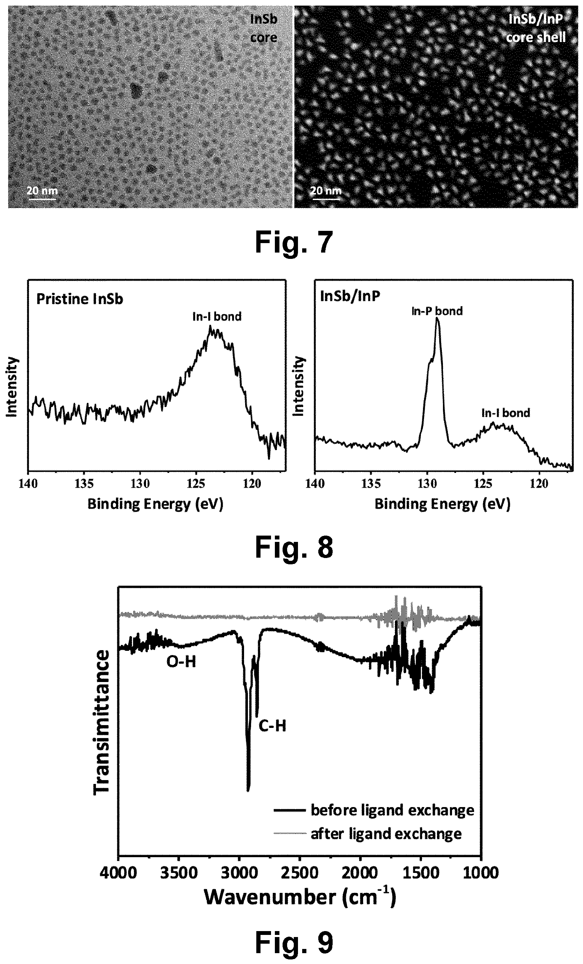

Fig. 2c shows the XRD patterns of corresponding InSb core and InSb/InP core-shell structure. The diffraction peak of InSb core at 23.8° shifts to higher angle at 24.3° after the InP shell growth. Importantly, The InSb core still maintains the crystal structure of zinc blende, and no extra diffraction peaks belonging to InP were observed. This suggests that pure InSb/InP core-shell structure was obtained without any phase segregation. TEM images confirmed the shape of CQDs evolved from near-spherical (Fig. 7 left) to tetrahedrally faceted after the growth of InP shell (Fig. 7 right), which is in agreement with Liu et al. [5] High angle annular dark field scanning transmission electron microscopy (HAADF-STEM, Fig. 2d) image showed the same lattice constant as InSb, indicating that no alloying structure has formed. The corresponding fast Fourier transform (FFT) pattern suggests InP shell grows along the [110] zone axis of InSb core. Moreover, energy-dispersive X-ray spectroscopy (EDX, Fig 2e-f) mapping also indicated a core-shell structure with P elements at the edge while Sb elements at the center.

XPS measurement was further employed to study the surface of InSb CQDs after InP shell growth. As shown in Fig. 2g, the proportion of Sb-O bonds at 539.9 eV and 530.6 eV in the pristine InSb CQDs is up to 34%, which indicates the presence of a large number of unpassivated Sb dangling bonds on the surface, probably acting as the trap states. However, it was decreased to 28% after the in-situ surface post-treatment with InCl3. Importantly, this value was further decreased to 7.5% or even disappeared completely after the growth of InP shell. This suggests the Sb dangling bonds on the surface of InSb/InP core-shell CQDs are effectively passivated, which is consistent with the enhancement of PL observed previously. In addition, P 2p XPS analysis was also executed before (Fig. 8 left) and after InP shell growth (Fig. 8 right) to prove the core-shell structure.

InSb/InP CQDs SWIR photodetectors:

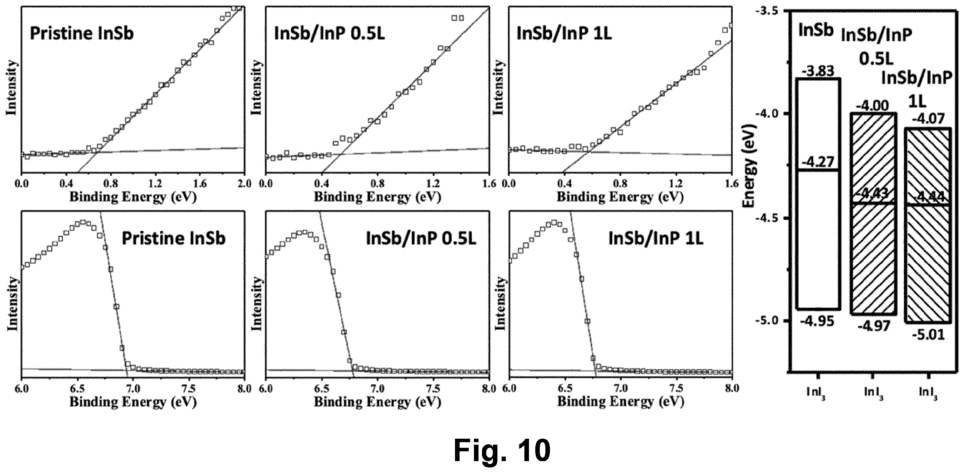

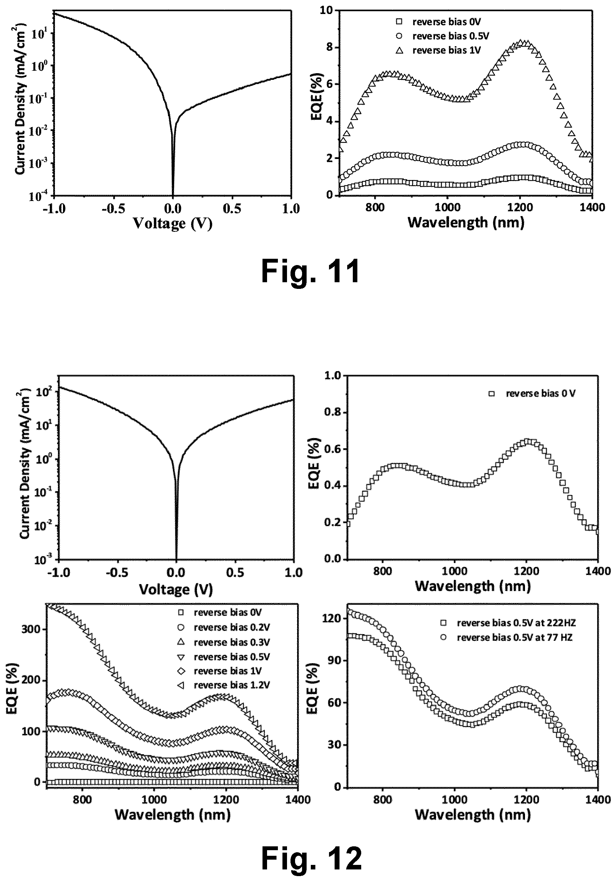

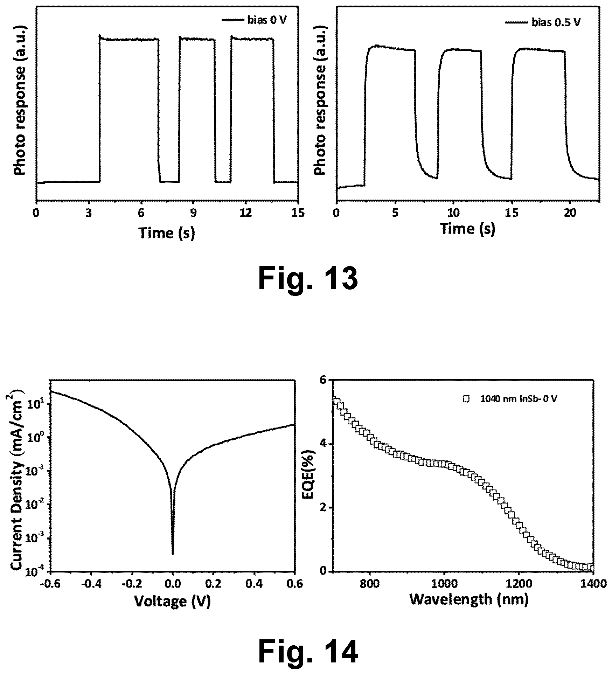

Having optimized the InSb/InP core-shell CQDs, the present inventors aimed to implement them into a low-temperature, solution-processed, SWIR photodetector. To improve the conductivity of CQDs film, $InI_3$ was chosen to replace the surface organic long chain ligand of InSb CQDs [2], performing a solid-state ligand exchange method. As shown in the Fourier transform infrared (FTIR) spectra (Fig. 9), the surface organic ligands of InSb CQDs were completely removed after the solid ligand exchange. The conduction band, valence band, and Fermi level of the InSb and InSb/InP core shell CQDs film were measured by the ultraviolet photoelectron spectroscopy (UPS, Fig. 10). Considering the energy levels of InSb CQD solids, the present inventors first designed a vertical device architecture consisting of indium-tin oxide (ITO)/ZnO/InSb/$MoO_x$/Au. The use of non-annealed ZnO layer was found to lead to a rectifying junction but characterized by a low EQE under bias conditions (Fig. 11). The present inventors then sought to perform annealing of the ZnO layer, which led to drastic deterioration of the rectification followed however by a dramatic increase of the measured EQE under bias. The fact that EQE was measured to exceed 100% under bias suggests that the device in those conditions exhibits some photoconductive gain. This was further supported by the EQE dependence on the modulation frequency up to 222 Hz (Fig. 12) and the slow response time of the detector under bias (Fig. 13). This photoconductor gain effect has also been observed in PbS QD devices by using ZnO as the electron transfer layer (ETL) and is ascribed to photogenerated carrier trapping in the ZnO layer due to photochemical reactions [19].

The present inventors were, instead, interested to address applications that go beyond video frame rate imaging such as gated imaging or indirect time-of-flight (iToF) which require detectors with faster response times (< 100 ns). The present inventors thus turned to the use of $TiO_2$ as the ETL which is known to exhibit photochemical stability as opposed to ZnO. The device architecture and band alignment are shown in Figs. 3a and 3b, where, for the illustrated embodiment, the device comprises:.

- a substrate S;
- an electron transporting structure T arranged over the substrate;
- a light-active absorbing structure A arranged over the electron transporting structure T and containing the quantum dot population of the first aspect of the present invention, made to absorb at least one of infrared light, near infrared light, and short-wavelength infrared light;
- an electronic blocking structure B arranged over the light-active absorbing structure; and
- a top electrode E2 arranged over the electronic blocking structure.

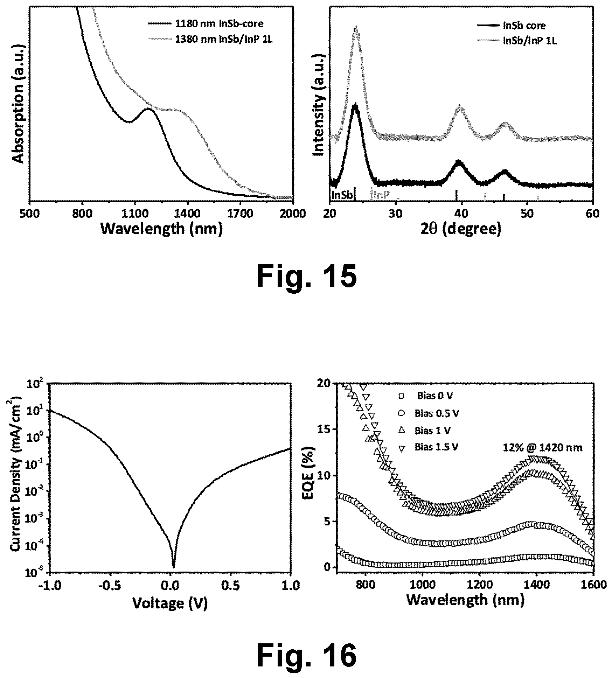

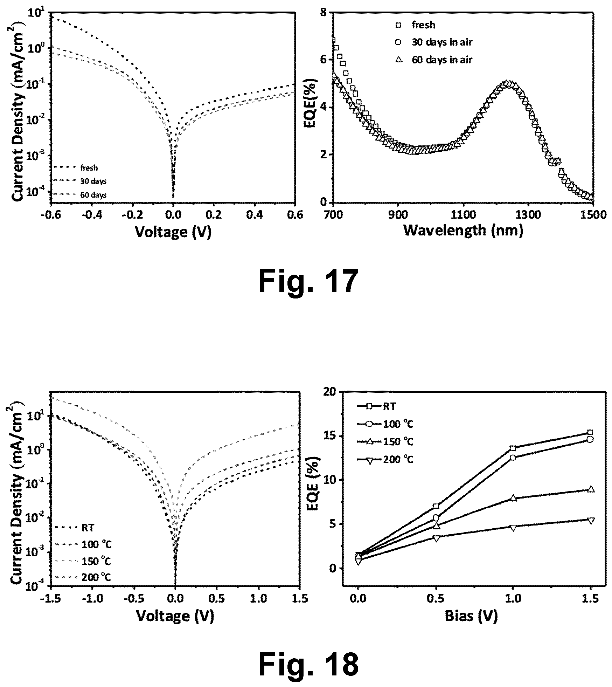

The current density-voltage (J-V) characteristic of pristine InSb CQDs photodetector exhibits poor rectification and low performance with EQE of 3% at 1100 nm under zero bias (Fig. 14). The rectification and external quantum efficiency (EQE) of InSb/InP core-shell CQDs photodetector have shown significant improvement (Figs. 3c-f), which suggests that our surface passivation strategy is effective. As shown in Fig. 3d, the EQE of InSb/InP CQDs photodetector with 0.5L InP shell is 5% at 1250 nm under 0V bias, and it reaches 25% under 2V bias. On the other hand, the EQE of InSb/InP CQDs photodetector with 1L InP shell is 1.8% at 1300 nm under 0V bias, and it reaches 15% under 1.5V bias (Fig. 3f). Furthermore, the present inventors also performed core-shell growth on larger-sized InSb CQDs. As shown in Fig. 15, the exciton absorption peak of the InSb/InP CQDs moved from 1180 nm to 1380 nm. Based on these In-Sb/InP core-shell CQDs, the corresponding photodetector was fabricated and the highest EQE of 12% at 1420 nm under bias was achieved (Fig. 16). In addition, the present inventors assessed air stability of InSb/InP CQDs photodetector (Fig. 17). Remarkably, even after two months of exposure to the ambient environment without any encapsulation, the device maintains its rectification properties and nearly identical EQE levels, demonstrating resilience to atmospheric conditions. Moreover, the present inventors investigated the thermal stability of the InSb/InP CQD photodetectors (Fig. 18). The obtained findings suggest that the device remains stable when subjected to annealing temperatures below 150 °C, pointing to a much better thermal stability than Pb-chalcogenide CQD counterparts.

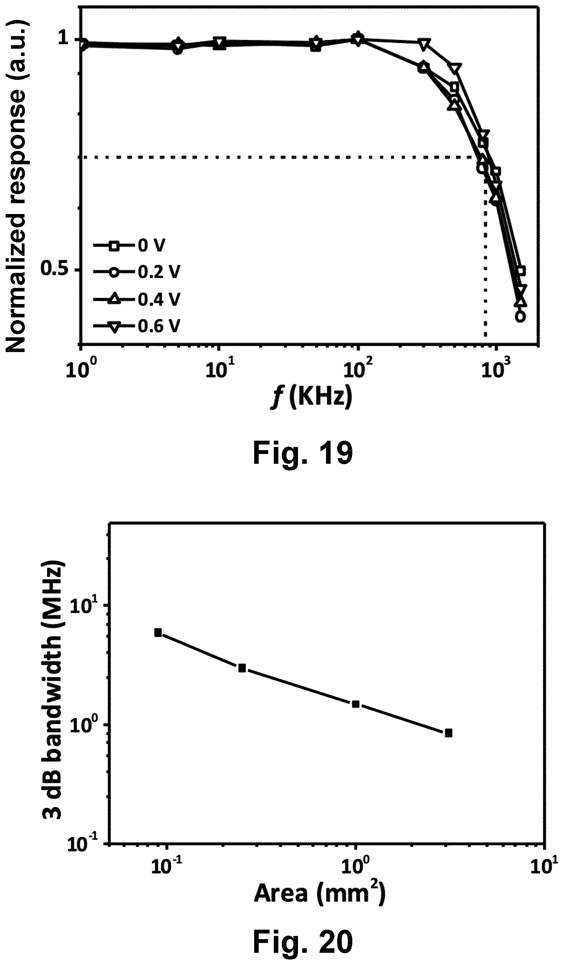

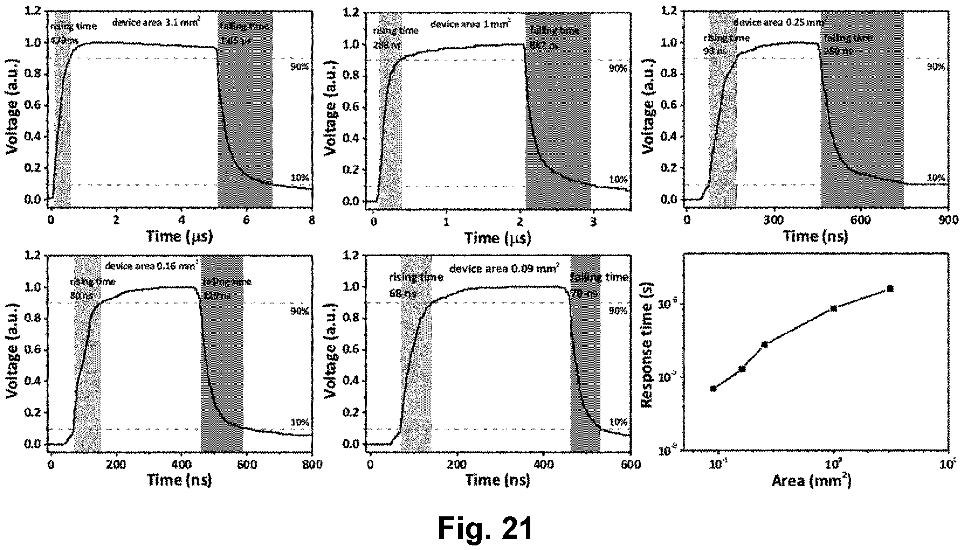

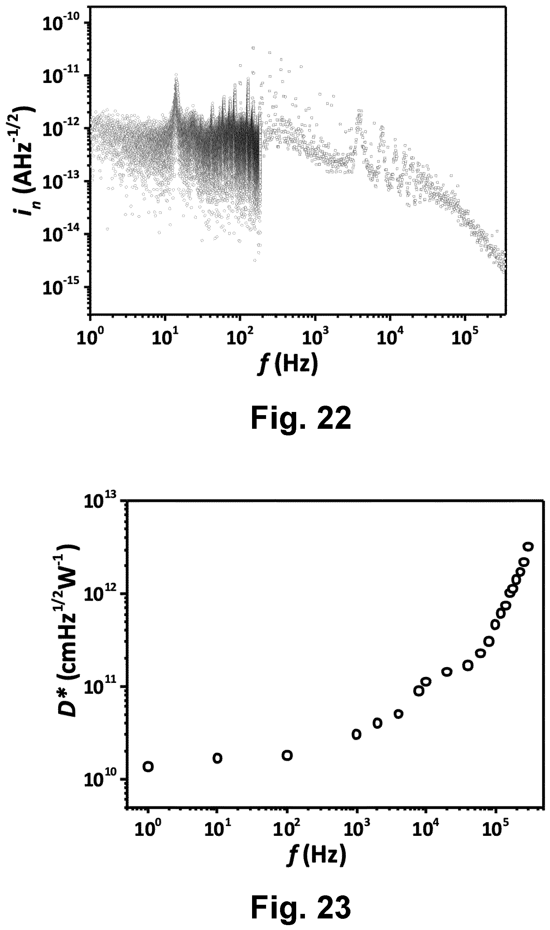

The frequency response measurement of In-Sb/InP CQDs photodetector was carried out to calculate the 3dB bandwidth. As indicated by the reference [18], the 3dB bandwidth could be limited by the resistor-capacitor (RC) time constant or carrier mobility depending on the thickness of active layer. To pinpoint the key factor in the present case, the present inventors measured the bias-dependent 3dB bandwidth (Fig. 19), the absence of bandwidth dependence on bias supports an RC-limited instead of mobility-limited 3dB bandwidth. Since the RC time is directly related to the device area, the device area-dependent 3dB bandwidth was measured. As shown in Fig. 4a and Fig. 20, the 3dB bandwidth increased from 850 kHz to 6 MHz when the device area decreased from $3.1 mm^2$ to $0.09 mm^2$. The transient response with different device areas (Fig. 2b and Fig. 21) revealed the falling-time reduction from 1.65 $\mu$s to 70 ns, respectively, in accordance with the observed 3dB bandwidth. The linear dynamic range (LDR) of InSb/InP CQDs photodetector was measured by varying the incident light intensity. As shown in Fig. 4c, the photocurrent maintained linearity with incident light power over a broad range and LDR is estimated to be over 128 dB. The frequency-dependent current noise spectrum of InSb/InP CQDs photodetector was measured with fast Fourier Transform (FFT) current transients for low frequency and a lock-in amplifier for high frequency range (Fig. 22). The obtained noise spectrum showed a 1/f noise dominating at low frequency and a generation-recombination noise at high frequency. The device reaches a noise floor of ~$3 * 10^{-15}$ A $Hz^{-0.5}$ at frequency of 300 kHz. The InSb/InP CQDs photodetector reached a maximum of D* ~ $3.6 \times 10^{12}$ Jones at 300 kHz at 1240 nm (Fig. 4d), and the frequency dependent D* was provided in Fig. 23.

Experimental Methods:

Chemicals:

Oleylamine (OLA, 80-90%) and Tris(trimethylsily)phosphine (($TMS)_3P$, 98%) were purchased from Thermal Scientific. Tris(dimethylamido)antimony-(III) ($Sb[NMe_2]_3$, 99.99%) and indium(III) chloride ($InCl_3$, 99.999%) were purchased from Strem Chemicals. Indium acetate (In($OAc)_3$, 99.99%), indium(III) iodide ($InI_3$, 99.998%), 1-octadecene (ODE, 90%), lithium triethylborohydride ($LiEt_3BH$, SuperHydride, 1 M in tetrahydrofuran, THF), dioctyl ether (DOE, 99%), oleic acid (OA, 90%), methanol (anhydrous, 99.8%) and toluene (anhydrous, 99.8%) were purchased from Sigma Aldrich. Acetone (anhydrous, 98%) was purchased from Scharlab. All chemicals were used as received except for oleylamine and oleic acid, which were degassed before use. The degassing was performed at 100 °C under reduced pressure (~1 mbar) for 4 h.

Preparation of Superhydride Solution:

$LiEt_3BH$ (1.0 M) dissolved in tetrahydrofuran (THF) is used as purchased. A 100 mL amount of the superhydride solution is added to 50 mL of degassed dioctyl ether (DOE) and then evacuated on the Schlenk line for >4 h, until the THF is completely removed. *Caution: $LiEt_3BH$ is very reactive in air and should be handled using air-free processes.* The final superhydride solution has a concentration of 2.0 M in DOE.

Preparation of the In-Sb Precursor Solution:

1.6 mL toluene, 400 uL of OLA (1.2 mmol), and 115 uL of $Sb[NMe_2]_3$ were mixed together in a glovebox under $N_2$ ($H_2O$ and $O_2$ < 0.1 ppm) yielding a bright yellow solution. Then 0.6 mmol $InCl_3$ was added and dissolved under stirring at room temperature for 5 min.

Preparation of 0.2 M ($TMS)_3$P-ODE solution:

1 mL ($TMS)_3$P solution was mixed with 16 mL degassed ODE, and the 0.2 M ($TMS)_3$P-ODE solution was formed.

Synthesis of InSb Colloidal Quantum Dots:

In a typical synthesis, 20 mL of degassed OLA was heated to 230 °C in a roundbottom flask under constant stirring and $N_2$. At this temperature, 4.5 mL of $LiEt_3BH$ in DOE (2.0 M, 9 mmol) was added in a dropwise manner within 2 min. During the addition, OLA acquired an orange color. Subsequently, 2 mL of the In-Sb precursor solution was pumped into the organic mixture with the pumping rate of 1 mL min$^{-1}$. After that, the temperature was kept at 230 °C for another 5 min and cooled down to room temperature naturally. The size of InSb CQDs could be tuned with the temperature from 220 °C to 250 °C.

InCl$_3$ Post-treatment for InSb Colloidal Quantum Dots:

Before the purification of InSb CQDs, 1.2 mmol InCl$_3$ was loaded in a roundbottom flask filled with N$_2$, and then the as synthesized InSb CQDs crude solution was transferred into the flask and heating to 200 °C from room temperature for 30 min for the post-treatment.

Purification of InSb Colloidal Quantum Dots:

After the post-treatment, the reaction solution was transferred into the plastic centrifuge tubes inside the glovebox. The reaction mixture was separated in two portions, oleic acid (2 mL) was added to each and rotated for 2 min. Then 24 mL of MeOH was added, leading to turbidity. Centrifugation for 10 min at 6000 rpm yielded a black precipitate and colorless supernatant. The colorless supernatant was discarded, and the black precipitate was redispersed in 10 mL of toluene, and centrifugation for more 10 min at 6000 rpm. The precipitate was discarded, then 2 mL oleic acid was added to the supernatant, and 15 mL of MeOH was added. Again, centrifugation for 10 min at 6000 rpm yielded a black precipitate and colorless supernatant. The colorless supernatant was discarded, and the black precipitate was redispersed in anhydrous toluene, resulting a 50 mg mL$^{-1}$ InSb CQDs solution.

Synthesis of InSb/InP Core Shell Colloidal Quantum Dots:

In a typical synthesis, 0.1 mmol In(OAc)$_3$, 0.3 mmol OA, and 10 mL octadecene were mixed in a 25 mL flask, and evacuated on the Schlenk line at 100 °C for 2h. Then the temperature was raised to 150 °C for the completely dissolving of In(OAc)$_3$. Next, the ODE solution was cooled down to 60 °C and 2 mL 50 mg mL$^{-1}$ InSb CQDs was added. After the addition of InSb CQDs, the solution was bubbled with N$_2$ for 30 minutes at 60 °C. Then 400 uL (TMS)$_3$P-ODE solution (0.2M) was added and the reaction temperature was raised to 250 °C (270 °C for the larger-sized InSb CQDs) for the growth of InP shell. After 30 min growth of InP shell, the reaction mixture was cooled down to room temperature naturally.

Purification of InSb/InP Core Shell Colloidal Quantum Dots:

The reaction mixture was transferred into the plastic centrifuge tubes inside the glovebox and centrifuged for 10 min at 6000 rpm. The precipitate was discarded and 30 mL of acetone was added to the supernatant. Centrifugation for 10 min at 6000 rpm yielded a black precipitate and colorless supernatant. The colorless supernatant was discarded, the black precipitate was redispersed in 10 mL of toluene, and repeated the wash process again. The final black precipitate was redispersed in anhydrous toluene, resulting a 50 mg mL$^{-1}$ InSb/InP CQDs solution for further characterization and device fabrication.

All of the synthesis and purification steps were carried out in an inert atmosphere under anhydrous conditions (N$_2$ glovebox, H$_2$O and O$_2$ < 0.1 ppm).

Characterization of the Quantum Dots:

UV-vis absorption measurements were performed with a Cary 5000 UV-Vis-NIR spectroscope in solution. For photoluminescence (PL) measurements, four channel Thorlabs laser was used as excitation light and a Kymera 328i spectrograph (Oxford Instruments, Andor) was used as the detector (<1600 nm). For the PLQY measurement, a 935 nm laser, an integration sphere and the Andor detector were used. The XRD data were collected using a Rigaku SmartLab powder diffractometer in the Bragg-Brentano geometry with Cu Kα radiation on drop-casted powder samples. TEM was performed at the Scientific and Technological Centres of the University of Barcelona. The TEM images were obtained using a JEOL 2100F microscope operating at an accelerating voltage of 200 kV. TEM samples were prepared by dropping diluted QD solution on ultrathin carbon grids. Scanning transmission electron microscopy (STEM) experiments were conducted using an FEI Titan G2 80-200 microscope at 200 kV equipped with a Cs-probe corrector and a HAADF detector. Elemental maps were taken by energy-dispersive X-ray spectroscopy (EDX) using four large-solid-angle symmetrical Si drift detectors. The XPS/UPS measurements were performed with a SPECS PHOIBOS 150 hemispherical analyser under ultrahigh-vacuum conditions (10$^{-10}$ mbar) at the Institut Català de Nanociència i Nanotecnologia.

Device fabrication:

All the device fabrication steps were carried out in ambient air. ITO-covered glass substrates (Universität Stuttgart, Institut für Großflächige Mikroelektronik) were cleaned by sonication in soapy water, acetone and isopropanol for 20 min each and dried with nitrogen, followed with 30 min ultraviolet/ozone treatment. TiOz electron transport layer was then deposited with a sputtering technique to achieve a thickness of ~ 40 nm. Three layers of InSb/InP CQDs were further spin-coated from 50 mg ml$^{-1}$ toluene solution via the layer-by-layer method. For each InSb/InP CQDs layer, one drop of InSb/InP CQDs solution was spin coated onto $TiO_2$/ITO substrates during spinning (2,000 r.p.m.). Then, 5 mg ml$^{-1}$ $InI_3$/Methanol solution was applied to the CQDs film for 30 s, followed by two rinse-spin steps with methanol and once with toluene. Finally, a Kurt J. Lesker NANO 36 system was used to deposit 10 nm $MoO_x$ as the electronic blocking layer and 100 nm Au as top electrode with a device area of 3.1 mm$^2$. The device with smaller device area was deposited with the special shadow mask.

Device Characterization:

All the device characterizations were performed in air under ambient conditions. Current-voltage (I-V) measurements were performed with a Keysight Semiconductor Parameter Analyzer (B1500A) with the devices kept in a shield box. The EQE was measured using a Newport Cornerstone 260 monochromator, a Thorlabs MC2000 chopper, a Stanford Research SR570 transimpedance amplifier and a Stanford Research SR830 lock-in amplifier. Calibrated Newport 818-UV and 818-IR photodetectors were used as the reference. In order to measure the 3dB bandwidth, nanosecond laser (520 nm) was used as incident light, which was modulated by a waveform generator (Agilent 33220A) at various frequencies with 50% duty cycle. The output current was recorded with an oscilloscope. For linear dynamic range measurements, four-channel laser (Thorlabs) at 1310 nm was used as light source at a frequency of 7 Hz modulated by Agilent waveform generator. The light was directed by a beam-splitter to a Newport 818-IG detector and the device. The current was amplified by an SR570 amplifier and recorded by an oscilloscope. For the noise measurements, devices were connected with Stanford Research SR830 lock-in amplifier directly. The measured room-temperature specific detectivity (D*) was calculated according to:

$$D^* = \frac{R\sqrt{A\Delta f}}{i_n}$$

where D* is expressed in units of cm Hz$^{1/2}$ W$^{-1}$ or Jones, A is the active area of the photodetector, $i_n$ is the noise current spectral density, and $\Delta f$ is the noise bandwidth, here being 1 Hz.

A person skilled in the art could introduce changes and modifications in the embodiments described without departing from the scope of the invention as it is defined in the attached claims.

References:

[1] Choi, M. et al. Ligand exchange at a covalent surface enables balanced stoichiometry in III-V colloidal quantum dots. Nano Lett. 21, 6057-6063 (2021).

[2] Sun, B. et al. Fast near-infrared photodetection using III-V colloidal quantum dots. Adv. Mater. 34, 2203039 (2022).

[3] Leemans, J. et al. Colloidal III-V quantum dot photodiodes for short-wave infrared photodetection. Adv. Sci. 9, 2200844 (2022).

[4] Goldbery, Y. A., Levinshtein, M., Rumyantsev, S. & Shur, M., E. Handbook series on semiconductor parameters. World Scientific: London, Vol.1, 191-213 (1996).

[5] Liu, W., Chang, A. Y., Schaller, R. D. & Talapin, D. V. Colloidal InSb nanocrystals. J. Am. Chem. Soc. 134, 20258-20261 (2012).

[6] Zhao, T. et al. General synthetic route to high-quality colloidal III-V semiconductor quantum dots based on pnictogen chlorides. J. Am. Chem. Soc. 141, 15145-15152 (2019).

[7] Busatto, S. et al. Luminescent colloidal InSb quantum dots from in situ generated single-source precursor. ACS Nano 14, 13146-13160 (2020).

[8] Fu, H. & Zunger, A. InP quantum dots: electronic structure, surface effects, and the redshifted emission. Phys. Rev. B 56, 1496 (1997).

[9] Xie, R. & Peng, X. Synthetic scheme for high-quality InAs nanocrystals based on self-focusing and one-pot synthesis of InAs-based core-shell nanocrystals. Angew. Chem. Int. Ed. 47, 7677-7680 (2008).

[10] Sagar, L. K. et al. Single-precursor intermediate shelling enables bright, narrow line width InAs/InZnP-based QD emitters. Chem. Mater. 32, 2919-2925 (2020).

[11] Zhao, X., Lim, L. J., Ang, S. S. & Tan, Z. Efficient short-wave infrared light-emitting diodes based on heavy-metal-free quantum dots. Adv. Mater. 34, 2206409 (2022).

[12] Kim, T. et al. Trap passivation in indium-based quantum dots through surface fluorination: mechanism and applications. ACS Nano 12, 11529-11540 (2018).

[13] Hughes, K. E., Stein, J. L., Friedfeld, M. R., Cossairt, B. M. & Gamelin D. R. Effects of surface chemistry on the photophysics of colloidal InP nanocrystals. ACS Nano 13, 14198-14207 (2019).

[14] Asor, L. et al. Zn-doped P-type InAs nanocrystal quantum dots. Adv. Mater. 35, 2208332 (2023).

[15] Zahn, D. R. T. et al. Raman spectroscopy of InSb/CdTe heterostructures: improved interface quality obtained by Cd overpressure during molecular beam epitaxial growth. Appl. Phys. Lett. 53, 2409-2410 (1988).

[16] Jean, J. et al. Radiative efficiency limit with band tailing exceeds 30% for quantum dot solar cells. ACS Energy Lett. 2, 2612-2624 (2017).

[17] Mello, J. C., Wittmann, H. F. & Friend, R. H. An improved experimental determination of external photoluminescence quantum efficiency, Adv. Mater.

9, 230-232 (1997).

[18] Najarian, A. M. et al. Sub-millimetre light detection and ranging using perovskites. Nat. Electron. 5, 511-518 (2022).

[19] Xu, K. et al. Large photomultiplication by charge-self-trapping for high-response quantum dot infrared photodetectors. ACS Appl. Mater. Interfaces 14, 14783-14790 (2022).

**Claims**

1. A quantum dot population comprising InSb quantum dots, **characterized in that** said InSb quantum dots have a core-shell structure, wherein in said core-shell structure the core is made of InSb and the shell is made of InP, said InP shell being made and arranged to passivate trap states, suppress Sb oxidation, and minimize interface dangling bonds of Sb to reduce surface defects, wherein less than 10% of Sb present in each quantum dot is oxidized.

2. The quantum dot population of claim 1, wherein the surface dangling bonds of the Sb of the InSb core are post-synthesis partially passivated with $InCl_3$, at least to minimize surface defects.

3. The quantum dot population of any of the previous claims, wherein the InP shell partially covers the respective InSb core

4. The quantum dot population of claim 1 or 2, wherein the InP shell fully covers the respective InSb core with at least one layer of InP, so that less than 1% of Sb present in each quantum dot is oxidized.

5. The quantum dot population of any of the previous claims, wherein the InSb core of the core-shell structure maintains the crystal structure of zinc blende.

6. The quantum dot population of any of the previous claims, wherein the core-shell structure is tetrahedrally faceted.

7. The quantum dot population of any of the previous claims, wherein the InP shell is grown along the [110] zone axis of the InSb core.

8. The quantum dot population of any of the previous claims, comprising quantum dots with distinct first excitonic peaks spanning from 900 nm to 1750 nm.

9. A method for obtaining the quantum dot population of any of the previous claims, **characterized in that** the method comprises obtaining said core-shell structure by providing a core made of InSb and providing thereon a shell made of InP made and arranged to passivate trap states, suppress Sb oxidation, and minimize interface dangling bonds of Sb to reduce surface defects.

10. The method of claim 9, comprising performing the following steps:

    - synthesizing InSb quantum dots via a continuous precursor injection process controlled by precisely adjusting the precursor conversion kinetics of a precursor continuously injected into a solution, for the separation of the nucleation and growth processes and avoid a secondary nucleation;
    - applying a surface post-synthesis treatment of the synthesized InSb quantum dots with $InCl_3$;
    - applying a purification process to the InSb quantum dots; and
    - shelling the purified InSb quantum dots with the InP shell.

11. The method of claim 10, wherein said shelling step comprises growing at least part of a layer of InP using indium alkylates and phosphine silylamide ($P[N(Si(Me)_3)_2]_3$) as precursors.

12. The method of claim 10 or 11, wherein said InSb quantum dots are organic ligands capped InSb quantum dots, and the method further comprises performing a solid-state ligand-exchange on surface of the InSb quantum dots, for providing the same with ligands with a shorter chain than said organic ligands.

13. An optoelectronic device, comprising the quantum dot population of any of claims 1 to 8.

14. The optoelectronic device of claim 13, constituting a photo-detector comprising:

    - a substrate (S);
    - an electron transporting structure (T) arranged over said substrate (S);
    - a light-active absorbing structure (A) arranged over said electron transporting structure (T) and containing the quantum dot population of any of claims 1 to 8, made to absorb at least one of infrared light, near infrared light, and short-wavelength infrared light;
    - an electronic blocking structure (B) arranged over said light-active absorbing structure (A); and
    - a top electrode (E) arranged over said electronic blocking structure.

15. The optoelectronic device of claim 14, further comprising an intermediate structure arranged between said electron transporting structure (T) and said light-active absorbing structure (A), wherein said intermediate structure has a lower free carrier density than the electron transporting structure (T), its conduction band is lower, with respect to vacuum, than that of the electron transporting structure (T) and larger than that of the light-active absorbing structure (A), and its bandgap lies in between the bandgap of the electron transporting structure (T) and that of the light-active absorbing structure (A).

Fig. 1

Fig. 2

**Fig. 3**

EP 4 570 878 A1

Fig. 4

**Fig. 5**

**Fig. 6**

**Fig. 7**

**Fig. 8**

**Fig. 9**

Fig. 10

**Fig. 11**

**Fig. 12**

Fig. 13

Fig. 14

**Fig. 15**

**Fig. 16**

# Fig. 17

# Fig. 18

Fig. 19

Fig. 20

**Fig. 21**

**Fig. 22**

**Fig. 23**

Europäisches Patentamt
European Patent Office
Office européen des brevets

# EUROPEAN SEARCH REPORT

**Application Number**

EP 23 38 3278

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | D. V. KRYLSKY: "Synthesis, Composition, Photoluminescence, and Stability of Properties of Colloidal InSb-Based Quantum Dots", TECHNICAL PHYSICS LETTERS., vol. 45, no. 8, 1 August 2019 (2019-08-01), pages 801-804, XP093163860, US ISSN: 1063-7850, DOI: 10.1134/S106378501908025X Retrieved from the Internet: URL:http://link.springer.com/article/10.11 34/S106378501908025X/fulltext.html> [retrieved on 2024-05-17] * page 801 - page 804 * | 1,2,4-9, 13 | INV. C09K11/02 C09K11/70 C09K11/75 H01L31/0304 |
| A | SUBHASHRI CHATTERJEE: "Solution-Processed InSb Quantum Dot Photodiodes for Short-Wave Infrared Sensing", ACS APPLIED NANO MATERIALS, vol. 6, no. 17, 17 August 2023 (2023-08-17), pages 15540-15550, XP093163859, ISSN: 2574-0970, DOI: 10.1021/acsanm.3c02221 Retrieved from the Internet: URL:https://pubs.acs.org/doi/pdf/10.1021/a csanm.3c02221> [retrieved on 2024-05-17] * Introduction * | 1-15 | **TECHNICAL FIELDS SEARCHED (IPC)** C09K H01L |

The present search report has been drawn up for all claims

| Place of search | Date of completion of the search | Examiner |
|---|---|---|
| The Hague | 22 May 2024 | Poole, Robert |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **CHOI, M. et al.** Ligand exchange at a covalent surface enables balanced stoichiometry in III-V colloidal quantum dots. *Nano Lett.*, 2021, vol. 21, 6057-6063
- **SUN, B. et al.** Fast near-infrared photodetection using III-V colloidal quantum dots. *Adv. Mater.*, 2022, vol. 34, 2203039
- **LEEMANS, J. et al.** Colloidal III-V quantum dot photodiodes for short-wave infrared photodetection. *Adv. Sci.*, 2022, vol. 9, 2200844
- **GOLDBERY, Y. A** ; **LEVINSHTEIN, M** ; **RUMYANTSEV, S.** ; **SHUR, M., E**. *Handbook series on semiconductor parameters. World Scientific: London*, 1996, vol. 1, 191-213
- **LIU, W** ; **CHANG, A. Y** ; **SCHALLER, R. D.** ; **TALAPIN, D. V**. Colloidal InSb nanocrystals. *J. Am. Chem. Soc.*, 2012, vol. 134, 20258-20261
- **ZHAO, T. et al.** General synthetic route to high-quality colloidal III-V semiconductor quantum dots based on pnictogen chlorides.. *J. Am. Chem. Soc.*, 2019, vol. 141, 15145-15152
- **BUSATTO, S et al.** Luminescent colloidal InSb quantum dots from in situ generated single-source precursor.. *ACS Nano*, 2020, vol. 14, 13146-13160
- **FU, H.** ; **ZUNGER, A**. InP quantum dots: electronic structure, surface effects, and the redshifted emission.. *Phys. Rev. B*, 1997, vol. 56, 1496
- **XIE, R** ; **PENG, X**. Synthetic scheme for high-quality InAs nanocrystals based on self-focusing and one-pot synthesis of InAs-based core-shell nanocrystals. *Angew. Chem. Int. Ed.*, 2008, vol. 47, 7677-7680
- **SAGAR, L. K. et al.** Single-precursor intermediate shelling enables bright, narrow line width InAs/InZnP-based QD emitters. *Chem. Mater*, 2020, vol. 32, 2919-2925
- **ZHAO, X** ; **LIM, L. J** ; **ANG, S. S** ; **TAN, Z**. Efficient short-wave infrared light-emitting diodes based on heavy-metal-free quantum dots. *Adv. Mater.*, 2022, vol. 34, 2206409
- **KIM, T et al.** Trap passivation in indium-based quantum dots through surface fluorination: mechanism and applications. *ACS Nano*, 2018, vol. 12, 11529-11540
- **HUGHES, K. E.** ; **STEIN, J. L** ; **FRIEDFELD, M. R** ; **COSSAIRT, B. M** ; **GAMELIN D. R**. Effects of surface chemistry on the photophysics of colloidal InP nanocrystals. *ACS Nano*, 2019, vol. 13, 14198-14207
- **ASOR, L. et al.** Zn-doped P-type InAs nanocrystal quantum dots. *Adv. Mater*, 2023, vol. 35, 2208332
- **ZAHN, D. R. T. et al.** Raman spectroscopy of InSb/CdTe heterostructures: improved interface quality obtained by Cd overpressure during molecular beam epitaxial growth. *Appl. Phys. Lett.*, 1988, vol. 53, 2409-2410
- **JEAN, J. et al.** Radiative efficiency limit with band tailing exceeds 30% for quantum dot solar cells. *ACS Energy Lett.*, 2017, vol. 2, 2612-2624
- **MELLO, J. C.** ; **WITTMANN, H. F.** ; **FRIEND, R. H**. An improved experimental determination of external photoluminescence quantum efficiency. *Adv. Mater*, 1997, vol. 9, 230-232
- **NAJARIAN, A. M. et al.** *Nat. Electron.*, 2022, vol. 5, 511-518
- **XU, K. et al.** Large photomultiplication by charge-self-trapping for high-response quantum dot infrared photodetectors. *ACS Appl. Mater. Interfaces*, 2022, vol. 14, 14783-14790